# EUROPÄISCHE PATENTSCHRIFT

(11) **EP 2 745 403 B1**
(45) Veröffentlichungstag und Bekanntmachung des Hinweises auf die Patenterteilung: **04.01.2017**
(21) Anmeldenummer: 12813750.2
(22) Anmeldetag: 16.08.2012
(51) Int. Cl.: H04N 19/42, H04N 19/176, H03M 5/14

(54) **DC-BALANCIERTE KODIERUNG FÜR VIDEOSIGNALEN**
DC-BALANCED CODING FOR VIDEO SIGNALS
CODAGE À COMPOSANTE CONTINUE ÉQUILIBRÉE POUR SIGNAUX VIDÉO

(30) Priorität: 16.08.2011 DE 102011052766
(43) Veröffentlichungstag der Anmeldung: 25.06.2014
(73) Patentinhaber: Silicon Line GmbH, 80687 München (DE)
(72) Erfinder: GROEPL, Martin, 87527 Sonthofen / Oberallgäu (DE); SUTTORP, Thomas, 80687 München (DE); JANSEN, Florian, 80687 München (DE)
(74) Vertreter: Hofmann, Andreas
(86) Internationale Anmeldenummer: PCT/DE2012/200056
(87) Internationale Veröffentlichungsnummer: WO 2013/023658

(56) Entgegenhaltungen:
- US-A- 6 111 528
- US-A1- 2009 323 831
- US-B1- 6 295 010

## Beschreibung

### Technisches Gebiet

Die vorliegende Erfindung betrifft grundsätzlich das technische Gebiet optischer und/oder elektrischer, insbesondere serialisierter, Signalverbindungen; im Spezielleren betrifft die vorliegende Erfindung eine Schaltungsanordnung gemäß dem Oberbegriff des Anspruchs 1 sowie ein Verfahren gemäß dem Oberbegriff des Anspruchs 10.

### Stand der Technik, insbesondere dessen Nachteile und technische Probleme

Displays in Mobiltelefonen, in Notebooks oder in tragbaren Spielkonsolen werden unter anderem über einen parallelen Datenbus angesteuert, der die Informationen über die Farbbits und die notwendigen Synchronisationsbits enthält. Werden derartige Daten parallel übertragen, erfordert diese parallele Datenübertragung ein breites Flachbandkabel oder relativ viel Platz auf einer Leiterplatte, wodurch unvorteilhafterweise eine weitere Miniaturisierung derartiger Geräte verhindert wird.

Es gibt bereits Verfahren, die diese parallelen Daten serialisieren und wieder deserialisieren, jedoch sind nur wenige dieser konventionellen Verfahren für eine D[irect]C[urrent]-balancierte Datenübertragung geeignet.

Verfahren, die eine derartige DC-balancierte Datenübertragung gewährleisten, haben aufgrund des verwendeten Kodier- und Dekodierverfahrens einen starken Überhang an zusätzlich zu übertragenden seriellen Bits. Werden die Daten nämlich serialisiert und deserialisiert, werden aufgrund der konventionellerweise verwendeten Kodier- und Dekodierverfahren entweder sehr viele zusätzliche Bits übertragen oder es ist mehr als eine differentielle Leitung zur Übertragung der Daten und des zugehörigen Taktsignals notwendig, wodurch das Ziel der Miniaturisierung derartiger Geräte wiederum konterkariert wird.

Um ein DC-balanciertes Signal zu erhalten, werden Kodier- und Dekodierverfahren mit verschiedenen Bitbreiten eingesetzt. Das wohl bekannteste Kodier-/Dekodierverfahren ist die 8b/10b-Kodierung/-Dekodierung (8b = acht Bit, 10b =zehn Bit). Eine derartige 8b/10b-Kodierung/-Dekodierung weist in den meisten Fällen
- einen 5b/6b-Kodierblock mit zugeordnetem 6b/5b-Dekodierblock und
- einen 3b/4b-Kodierblock mit zugeordnetem 4b/3b-Dekodierblock
   auf.

Als Grundlage für derartige 5b/6b-Blöcke und 3b/4b-Blöcke werden zumeist die Anleitung und die Tabelle von Albert X. Widmer (IBM Research Division) eingesetzt. Zum diesbezüglichen technologischen Hintergrund der vorliegenden Erfindung kann exemplarisch auf die Druckschrift US 6 911 921 B2 aus dem Stand der Technik aufmerksam gemacht werden.

Aus der US 6 111 528 und aus der US 6 295 010 B1 sind Schaltungsanordnungen zur DC-balancierten Kodierung eines Datenstroms bekannt, die eine Mehrzahl von parallel angeordneten 8b/10b-Kodierblöcken beinhalten. Gemäß der US 6 295 010 B1 besteht jeder von zwei vorgesehenen 8b/10b-Kodierblöcken aus einem 5b/6b-Kodierblock und einem 3b/4b-Kodierblock, die parallel angeordnet sind. Sowohl gemäß der US 6 111 528 wie auch gemäß der US 6 295 010 B1 wird ein Disparitätsbit von jedem Kodierblock zum jeweils nächsten weitergeleitet.

Die US 2009/0323831 A1 offenbart die konventionelle T[ransition]-M[inimized]D[ifferential]S[ignaling]-Kodierung von 8 Bit-Videodaten und 2 Bit-Kontrolldaten. Die Kodierungsanordnung enthält drei parallel angeordnete Kodierblöcke, die je nach Eingang entweder zur 8b/10b-Kodierung oder zur 2b/10b-Kodierung verwendet werden. Es wird jedoch keine Disparitätsinformation zwischen den Kodierblöcken ausgetauscht.

### Darstellung der vorliegenden Erfindung: Aufgabe, Lösung, Vorteile

Ausgehend von den vorstehend dargelegten Nachteilen und Unzulänglichkeiten sowie unter Würdigung des umrissenen Standes der Technik liegt der vorliegenden Erfindung die Aufgabe zugrunde, eine Schaltungsanordnung der eingangs genannten Art sowie ein Verfahren der eingangs genannten Art so weiterzuentwickeln, dass eine effiziente, insbesondere möglichst overheadarme, DC-balancierte Kodierung und/oder Dekodierung möglich ist.

Diese Aufgabe wird durch eine Schaltungsanordnung mit den Merkmalen des Anspruchs 1 sowie durch ein Verfahren mit den Merkmalen des Anspruchs 5 gelöst, insbesondere durch das Kodieren und/oder Dekodieren, zum Beispiel von 24 Bit-R[ot]G[rün]B[lau]-Videosignalen, unter Verwendung einer 27 Bit/32 Bit-Kodierung/-Dekodierung, mittels derer es möglich ist, die zu übertragenden Daten so zu kodieren und/oder zu dekodieren, dass nur sehr wenige zusätzliche Bits für eine DC-balancierte serielle optische und/oder elektrische Datenverbindung oder -übertragung anfallen; der anfallende Daten-Overhead ist also sehr klein.

Vorteilhafte Ausgestaltungen und zweckmäßige Weiterbildungen der vorliegenden Erfindung sind in den jeweiligen Unteransprüchen gekennzeichnet.

Mittels der vorliegenden Erfindung ist zum einen die Erzeugung eines 32 Bit langen Datenworts möglich, der für eine DC-balancierte serielle Datenübertragung geeignet ist, zum anderen die Dekodierung dieses 32 Bit langen Datenworts in ein fehlerfreies 27 Bit breites Datenwort.

Hierzu werden erfindungsgemäß
- auf der Kodierseite fünf 5b/6b-Kodierblöcke sowie ein 2b/2b-Kodierblock und
- auf der Dekodierseite fünf 6b/5b-Dekodierblöcke sowie ein 2b/2b-Dekodierblock
   eingesetzt, wobei der 5b/6b-Code (auch 5b6b-Code) ein Leitungscode ist, bei dem 5 Bit-Daten mit sechs Bit kodiert werden, so dass zum einen ein Gleichspannungsausgleich (D[irect]C[urrent]-Balance) gewährleistet ist und zum anderen eine Taktrückgewinnung aus
   dem Datensignal möglich ist.

Der mittels der 5b/6b-Kodierung erzeugte Datenstrom hat einen Overhead von zwanzig Prozent gegenüber dem ursprünglichen Datenstrom, was jedoch im Vergleich zur ebenfalls gebräuchlichen 4b/5b-Kodierung insofern einen Fortschritt darstellt, als bei der 4b/5b-Kodierung die Bruttodatenrate gegenüber der Netto- oder Nutzdatenrate (sogenannte pay load) infolge des Daten-Overheads um 25 Prozent erhöht ist.

Der erfindungsgemäß des Weiteren eingesetzte 2b/2b-Kodierblock und 2b/2b-Dekodierblock sorgen unter Einsatz der Disparitätsinformation dafür, dass von vier möglichen Eingangsinformationen (nämlich 00, 01, 10, 11) drei für die Erzeugung eines DC-balancierten Signals eingesetzt werden können.

Diese Nutzung von drei der vier möglichen Eingangssignale ist zweckmäßigerweise möglich, wenn an die beiden Dateneingänge das D[ata]E[nable]-Signal und das H[orizontal]S[ynchronisation]-Signal angeschlossen werden, wobei auf die Methodik gemäß VESA-Standard Bezug genommen werden kann; vgl. http://www.vesa.org/

Die vorliegende Erfindung stellt eine Möglichkeit zur Verfügung, die Anzahl der zu übertragenden kodierten und mittels mindestens eines diesem Kodieren nachgeordneten Multiplexens serialisierten Bits zu verringern, ohne die übertragene Nutzdatenmenge zu verringern; dies wiederum führt dazu, dass die erforderliche Bruttodaten-Übertragungsrate geringer wird, was wiederum eine verminderte Leistungsaufnahme einer seriellen Datenübertragung nach sich zieht.

Exemplarisch lässt sich die vorliegende Erfindung bei der gebündelten oder serialisierten optischen und/oder elektrischen Signalübertragung zwischen mindestens einer bis zu 24 Bit breiten digitalen R[ot]G[rün]B[lau]-Datenquelle, insbesondere mindestens einer, zum Beispiel hochauflösenden und/oder zum Beispiel als Bildquelle fungierenden, Kamera oder mindestens einem Applikationsprozessor, und mindestens einer bis zu 24 Bit breiten digitalen R[ot]G[rün]B[lau]-Datensenke, insbesondere mindestens einem Applikationsprozessor oder mindestens einem, zum Beispiel hochauflösenden und/oder zum Beispiel als Bildsenke fungierenden, Display oder Monitor, anwenden.

Hierbei ist es grundsätzlich möglich, die Signalverbindung
- auf optischer Basis, insbesondere auf Basis mindestens eines optischen Mediums, zum Beispiel auf Basis mindestens eines optischen Wellenleiters, wie etwa auf Basis mindestens einer Glasfaser und/oder auf Basis mindestens einer Plastikfaser, und/oder
- auf elektrischer oder galvanischer Basis, insbesondere auf Basis mindestens einer elektrischen oder galvanischen Verbindung, zum Beispiel auf Basis mindestens eines Kupferkabels und/oder auf Basis mindestens einer, etwa auf mindestens einer Leiterplatte angeordneten, elektrischen Leitung,
   zu realisieren und zu betreiben.

### Kurze Beschreibung der Zeichnungen

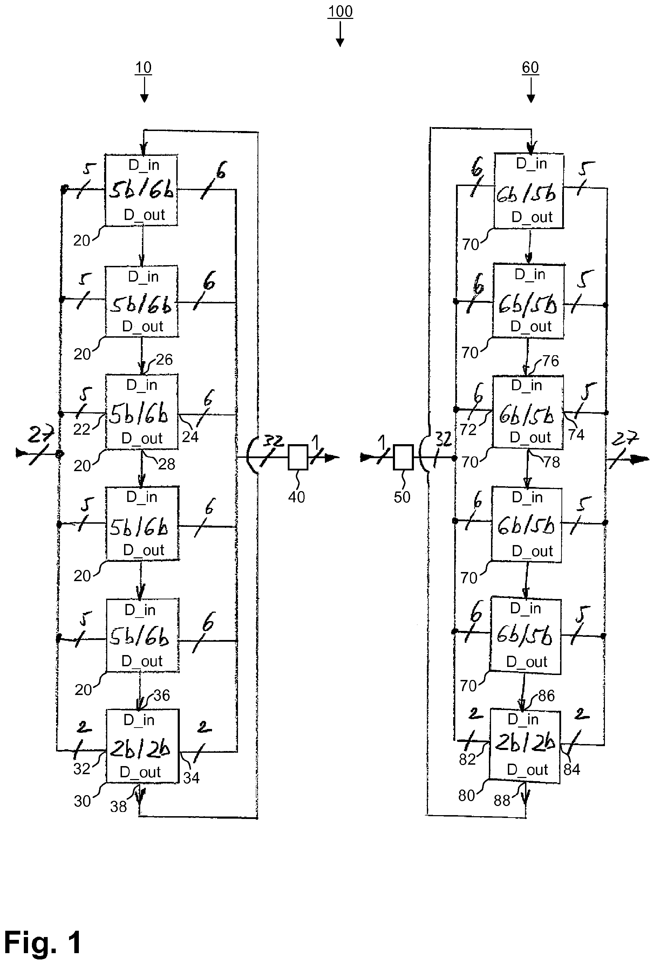

Wie bereits vorstehend erörtert, gibt es verschiedene Möglichkeiten, die Lehre der vorliegenden Erfindung in vorteilhafter Weise auszugestalten und weiterzubilden. Hierzu wird einerseits auf die dem Anspruch 1 sowie dem Anspruch 10 nachgeordneten Ansprüche verwiesen, andererseits werden weitere Ausgestaltungen, Merkmale und Vorteile der vorliegenden Erfindung nachstehend unter Anderem anhand des durch Fig. 1 bis Fig. 3B veranschaulichten Ausführungsbeispiels näher erläutert. Es zeigt:
- Fig. 1: in konzeptuell-schematischer Darstellung ein Ausführungsbeispiel für eine Schaltungsanordnung gemäß der vorliegenden Erfindung, die nach dem Verfahren gemäß der vorliegenden Erfindung arbeitet;
- Fig. 2: ein Ausführungsbeispiel für eine auf Albert X. Widmer (IBM Research Division) zurückgehende 5b/6b-Kodiertabelle, mittels derer fünf Eingangsbits in sechs Ausgangsbits gewandelt werden können und die bei der vorliegenden Erfindung zum Einsatz gelangen kann;
- Fig. 3A: ein Ausführungsbeispiel für eine von insgesamt 24 möglichen 2b/2b-Kodiertabellen, mittels derer zwei Eingangsbits in zwei Ausgangsbits gewandelt werden können und die bei der vorliegenden Erfindung zum Einsatz gelangen können; und
- Fig. 3B: die weiteren 23 möglichen 2b/2b-Kodiertabellen, die zur 2b/2b-Kodiertabelle aus Fig. 3A gleichwertig sind und mittels derer zwei Eingangsbits in zwei Ausgangsbits gewandelt werden können.

Gleiche oder ähnliche Ausgestaltungen, Elemente oder Merkmale sind in Fig. 1 bis Fig. 3B mit identischen Bezugszeichen versehen.

### Bester Weg zur Ausführung der vorliegenden Erfindung

Mittels der anhand Fig. 1 veranschaulichten Schaltungsanordnung 100 gemäß der vorliegenden Erfindung kann ein Datenstrom aus bis zu 24 Bit breiten R[ot]G[rün]B[lau]-Videosignalen kodiert (<--> Kodierer 10) und dekodiert (<--> Dekodierer 60) werden.

Hierzu weist die Schaltungsanordnung 100
- auf der Kodierseite den Kodierer 10
   -- mit fünf parallel zueinander angeordneten 5b/6b-Kodierblöcken 20 und
   -- mit einem parallel zu den 5b/6b-Kodierblöcken 20 angeordneten 2b/2b-Kodierblock 30 sowie
- auf der Dekodierseite einen Dekodierer 60
   -- mit fünf parallel zueinander angeordneten 6b/5b-Dekodierblöcken 70 und
   -- mit einem parallel zu den 6b/5b-Dekodierblöcken 70 angeordneten 2b/2b-Dekodierblock 80
auf.

Mittels des Kodierers 10 ist die Erzeugung eines eine Sequenz von beliebig vielen 32 Bit langen Datenwörtern aufweisenden Datenstroms möglich, der für eine DC-balancierte serialisierte Datenübertragung zwischen dem Kodierer 10 und dem Dekodierer 60 geeignet ist. Hierbei wird die Serialisierung mittels eines 32-zu-1-Multiplexers 40 (sogenannter Mux) realisiert, der dem Kodierer 10 nachgeschaltet ist und dafür sorgt, dass der Datenstrom in serieller Folge ausgegeben werden kann.

Für die Kodierung kann jeder der fünf 5b/6b-Kodierblöcke 20 durch seinen Dateneingang 22 fünf Bit breite digitale Signale aufnehmen und in sechs Bit breite Signale wandeln, die durch den jeweiligen Datenausgang 24 ausgegeben werden (in Fig. 1 sind die Bezugszeichen 22, 24 anhand des mittleren der fünf 5b/6b-Kodierblöcke 20 veranschaulicht, gelten aber für alle fünf 5b/6b-Kodierblöcke 20 in gleicher Weise).

Des Weiteren weist jeder der fünf 5b/6b-Kodierblöcke 20 einen Disparitätseingang 26 für die eingehende Disparitätsinformation D_in und einen Disparitätsausgang 28 für die ausgehende Disparitätsinformation D_out auf, denn es wird neben den Daten auch die Disparität verarbeitet (in Fig. 1 sind die Bezugszeichen 26, 28 anhand des mittleren der fünf 5b/6b-Kodierblöcke 20 veranschaulicht, gelten aber für alle fünf 5b/6b-Kodierblöcke 20 in gleicher Weise).

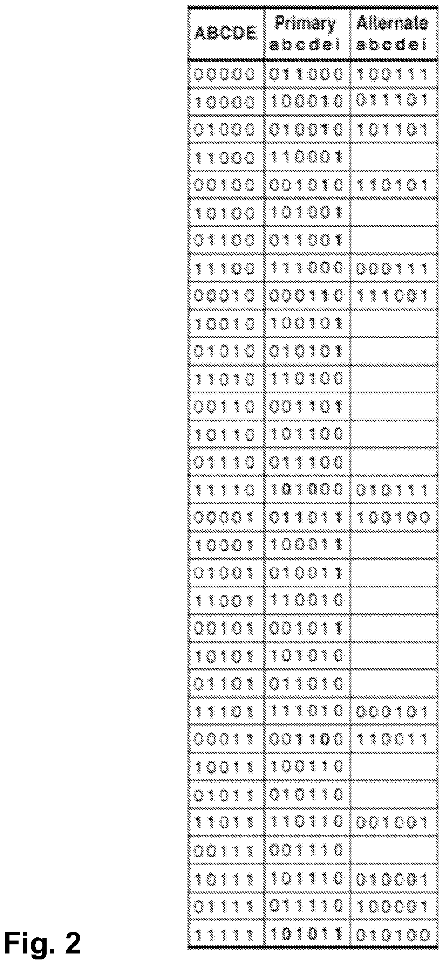

Exemplarisch kann für diese 5b/6b-Wandlung die anhand Fig. 2 veranschaulichte

Kodiertabelle von Albert X. Widmer (IBM Research Division) eingesetzt werden. So sind in Fig. 2 die fünf einzelnen Bits der 5 Bit-Eingangswörter mit den Buchstaben A, B, C, D, E bezeichnet; des Weiteren sind in Fig. 2 die sechs einzelnen Bits der 6 Bit-Ausgangswörter mit den Buchstaben a, b, c, d, e, i bezeichnet. Das 5b/6b-Kodierverfahren stellt also über den Dateneingang 22 eingehende 5 Bit-Wörter A B C D E über die exemplarische Kodiertabelle gemäß Fig. 2 in Form von über den Datenausgang 24 ausgehenden 6 Bit-Symbolen a b c d e i dar.

Von den 32 zu übertragenden 5 Bit-Eingangswörtern A B C D E wird ein Teil in 6 Bit-Ausgangssymbole a b c d e i gewandelt, die eine identische Anzahl von Nullen und Einsen, nämlich jeweils drei Nullen und drei Einsen enthalten und demzufolge als balanced oder D[irect]C[urrent]-balanced oder D[irect]C[urrent]-neutral bezeichnet werden, also gleichstromneutral übertragbar sind. So werden exemplarisch gemäß der Kodiertabelle in Fig. 2 neunzehn der 32 zu übertragenden 5 Bit-Eingangswörter A B C D E in gleichstromneutral übertragbare 6 Bit-Ausgangssymbole a b c d e i gewandelt.

Der restliche Teil der 32 zu übertragenden 5 Bit-Eingangswörter A B C D E wird in 6 Bit-Ausgangssymbole a b c d e i gewandelt, die nicht eine identische Anzahl von Nullen und Einsen enthalten, sondern
- entweder vier Nullen und zwei Einsen
- oder zwei Nullen und vier Einsen
   und demzufolge als unbalanced oder D[irect]C[urrent]-unbalanced oder nicht-D[irect]C[urrent]-neutral bezeichnet werden, also für sich allein genommen nicht gleichstromneutral übertragbar wären.

So werden exemplarisch gemäß der Kodiertabelle in Fig. 2 dreizehn der 32 zu übertragenden 5 Bit-Eingangswörter A B C D E in nicht gleichstromneutral übertragbare 6 Bit-Ausgangssymbole a b c d e i gewandelt. Für diese dreizehn Eingangssymbole A B C D E gibt es also jeweils zwei mögliche Ausgangssymbole, nämlich Primary a b c d e i und Alternate a b c d e i. Ob nun das erste Ausgangssymbol, also Primary a b c d e i, oder das zweite Ausgangssymbol, also Alternate a b c d e i, verwendet wird, hängt vom jeweils zuvor gesendeten unbalancierten Ausgangssymbol ab.

Parallel zu den fünf 5b/6b-Kodierblöcken 20 ist ein 2b/2b-Kodierblock 30 geschaltet, der ebenfalls einen Dateneingang 32 und einen Datenausgang 34 aufweist. Des Weiteren weist der 2b/2b-Kodierblock 30 einen Disparitätseingang 36 für die eingehende Disparitätsinformation D_in und einen Disparitätsausgang 38 für die ausgehende Disparitätsinformation D_out auf, denn es wird neben den Daten auch die Disparität verarbeitet.

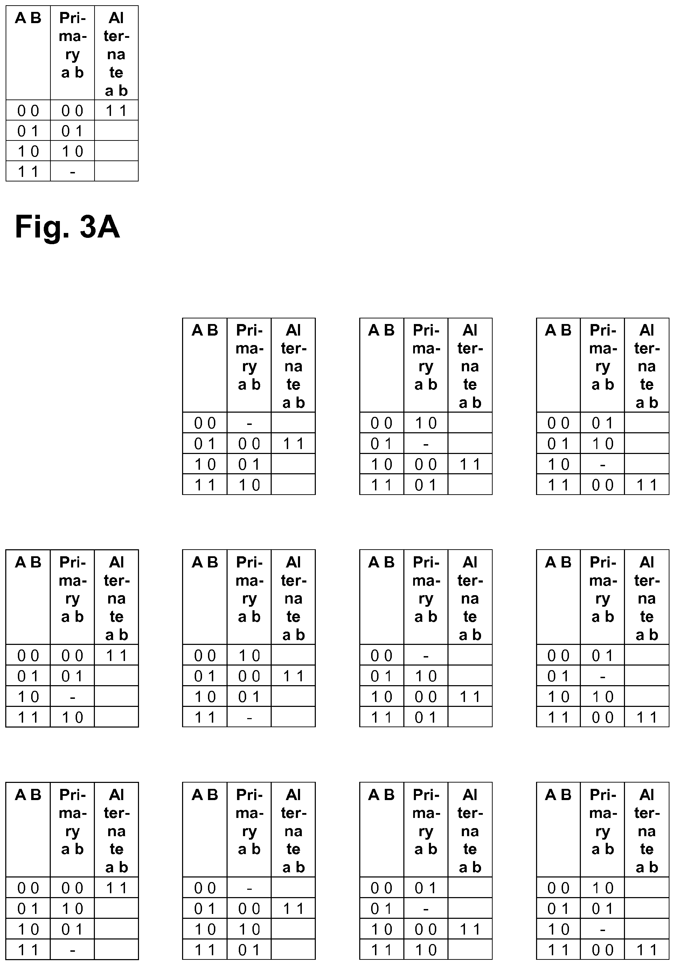

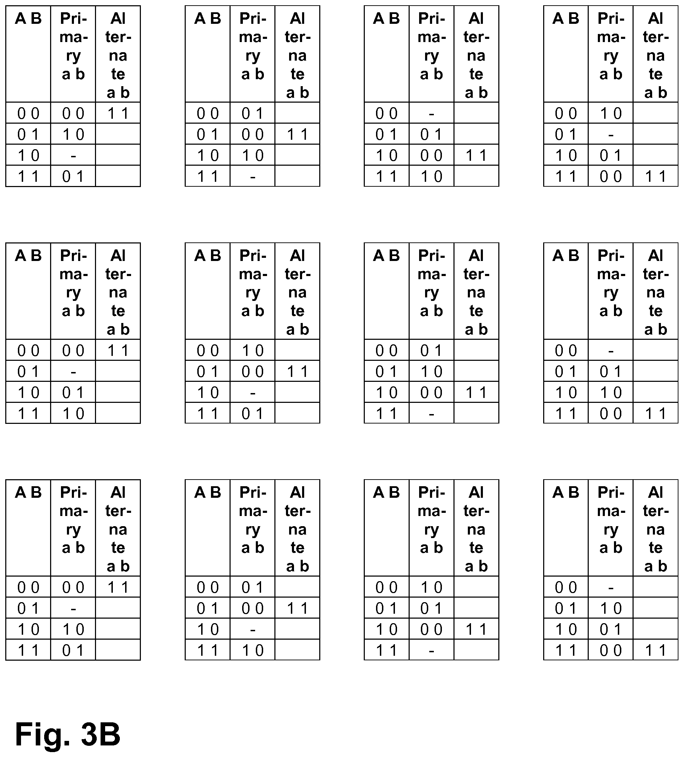

Exemplarisch kann für diese 2b/2b-Wandlung die anhand Fig. 3A veranschaulichte Kodiertabelle eingesetzt werden. Die weiteren 23 möglichen 2b/2b-Kodiertabellen, die zur 2b/2b-Kodiertabelle aus Fig. 3A gleichwertig sind und mittels derer zwei Eingangsbits in zwei Ausgangsbits gewandelt werden können, sind anhand Fig. 3B veranschaulicht.

So sind in Fig. 3A die zwei einzelnen Bits der 2 Bit-Eingangswörter mit den Buchstaben A, B bezeichnet; des Weiteren sind in Fig. 3A die zwei einzelnen Bits der 2 Bit-Ausgangswörter mit den Buchstaben a, b bezeichnet. Das 2b/2b-Kodierverfahren stellt also über den Dateneingang 32 eingehende 2 Bit-Wörter A B über die exemplarische Kodiertabelle gemäß Fig. 3A in Form von über den Datenausgang 34 ausgehenden 2 Bit-Symbolen a b dar.

Von den vier 2 Bit-Eingangswörtern A B wird ein Teil in 2 Bit-Ausgangssymbole a b gewandelt, die eine identische Anzahl von Nullen und Einsen, nämlich jeweils eine Null und eine Eins enthalten und demzufolge als balanced oder D[irect]C[urrent]-balanced oder D[irect]C[urrent]-neutral bezeichnet werden, also gleichstromneutral übertragbar sind. So werden gemäß der exemplarischen Kodiertabelle in Fig. 3A die beiden zu übertragenden 2 Bit-Eingangswörter 0 1 (also A = 0, B = 1) bzw. 1 0 (also A = 1, B = 0) in gleichstromneutral übertragbare 2 Bit-Ausgangssymbole 0 1 (also a = 0, b = 1) bzw. 1 0 (also a = 1, b = 0) gewandelt.

Vom restlichen Teil der vier 2 Bit-Eingangswörtern A B wird gemäß der exemplarischen Kodiertabelle in Fig. 3A eines in 2 Bit-Ausgangssymbole a b gewandelt, die nicht eine identische Anzahl von Nullen und Einsen enthalten, sondern
- entweder zwei Nullen
- oder zwei Einsen
   und demzufolge als unbalanced oder D[irect]C[urrent]-unbalanced oder nicht-D[irect]C[urrent]-neutral bezeichnet werden, also für sich allein genommen nicht gleichstromneutral übertragbar wären.

So wird gemäß der exemplarischen Kodiertabelle in Fig. 3A das zu übertragenden 2 Bit-Eingangswort 0 0 (also A = 0, B = 0) in ein nicht gleichstromneutral übertragbares 2 Bit-Ausgangssymbole 0 0 (also a = 0, b = 0) oder 1 1 (also a = 1, b = 1) gewandelt. Für dieses Eingangssymbol 0 0 (also A = 0, B = 0) gibt es also zwei mögliche Ausgangssymbole, nämlich Primary a b (= 0 0) und Alternate a b (= 1 1). Ob nun das erste Ausgangssymbol, also Primary a b, oder das zweite Ausgangssymbol, also Alternate a b, verwendet wird, hängt vom jeweils zuvor gesendeten unbalancierten Ausgangssymbol ab.

Das vierte (= im Ausführungsbeispiel der Fig. 3A das 2 Bit-Eingangswort 1 1, also A = 1, B = 1) der vier 2 Bit-Eingangswörtern A B wird gemäß der exemplarischen Kodiertabelle in Fig. 3A nicht benötigt bzw. benutzt. Der 2b/2b-Kodierblock 30 sorgt also unter Einsatz der Disparitätsinformation dafür, dass drei (nämlich 0 0, 0 1, 1 0) von vier möglichen 2 Bit-Eingangswörtern A B (= 0 0, 0 1, 1 0, 1 1) so innerhalb des 32 Bit-Ausgangsdatenworts eingearbeitet oder eingesetzt werden können, dass der aus einer seriellen Folge derartiger 32 Bit-Ausgangsdatenwörter zusammengesetzte Ausgangsdatenstrom unabhängig von den zu kodierenden 27 Eingangssignalen stets DC-balanciert ist.

Die Beschränkung auf drei der vier möglichen Eingangssignale 0 0, 0 1, 1 0, 1 1 am Eingang des 2b/2b-Kodierblocks 30 ist insbesondere dann mit Vorteil möglich, wenn an die beiden Dateneingänge 32 bzw. Datenausgänge 34 das D[ata]E[nable]-Signal und das H[orizontal]S[ynchronisation]-Signal angeschlossen werden, denn diese beiden Signale sind ohne zeitliche Koinzidenz übermittelbar.

Die Entscheidung,
- ob durch den 5b/6b-Kodierblock 20
   -- dasjenige unbalancierte 6 Bit-Ausgangssymbol a b c d e i mit vier Nullen und zwei Einsen oder
   -- dasjenige unbalancierte 6 Bit-Ausgangssymbol a b c d e i mit zwei Nullen und vier Einsen bzw.
- ob durch den 2b/2b-Kodierblock 30
   -- dasjenige unbalancierte 2 Bit-Ausgangssymbol a b mit zwei Nullen und keiner Eins oder
   -- dasjenige unbalancierte 2 Bit-Ausgangssymbol a b mit keiner Null und zwei Einsen übertragen wird, wird anhand der eingehenden Disparitätsinformation D_in bestimmt. Mittels dieser technischen Maßnahme können unbalancierte 6 Bit-Ausgangssymbole a b c d e i durch den 5b/6b-Kodierblock 20 bzw. unbalancierte 2 Bit-Ausgangssymbole a b durch den 2b/2b-Kodierblock 30 gleichstromfrei übertragen werden.

Zu diesem Zweck wird bei der Übertragung von aufeinander folgenden unbalancierten Ausgangssymbolen alternierend jeweils ein Symbol aus der einen Gruppe (= mit einem Überschuss von zwei Nullen, also mit vier Nullen und zwei Einsen im Falle eines unbalancierten 6 Bit-Ausgangssymbols a b c d e i bzw. mit zwei Nullen und keiner Eins im Falle eines unbalancierten 2 Bit-Ausgangssymbols a b) gefolgt von einem Symbol aus der anderen Gruppe (= mit einem Überschuss von zwei Einsen, also mit zwei Nullen und vier Einsen im Falle eines unbalancierten 6 Bit-Ausgangssymbols a b c d e i bzw. mit keiner Null und zwei Einsen im Falle eines unbalancierten 2 Bit-Ausgangssymbols a b) übertragen. Hierdurch liegt in zeitlicher Mittelung eine ausgeglichene Bitfolge aus Nullen und Einsen und demzufolge eine gleichstromfreie Übertragung vor.

Hierbei wird jedem der 5b/6b-Kodierblöcke 20 sowie dem 2b/2b-Kodierblock 30 des Kodierers 10 über den jeweiligen Disparitätseingang 26 bzw. 36 anhand der eingehenden Disparitätsinformation D_in mitgeteilt, ob das Ausgangssymbol a b, wenn es nicht DC-balanciert ist,
- negative Disparität, also zwei Nullen mehr als Einsen, das heißt
   -- vier Nullen und zwei Einsen im Falle des 5b/6b-Kodierblocks 20 bzw.
   -- zwei Nullen und keine Eins im Falle des 2b/2b-Kodierblocks 30 oder
- positive Disparität, also zwei Einsen mehr als Nullen, das heißt
   -- zwei Nullen und vier Einsen im Falle des 5b/6b-Kodierblocks 20 bzw.
   -- keine Null und zwei Einsen im Falle des 2b/2b-Kodierblocks 30
aufweisen soll.

In einem derartigen Falle des Ausgebens eines nicht DC-balancierten Ausgangssymbols wird der Zustand der als Binärsignal (= 0 oder 1) ausgebildeten Disparitätsinformation invertiert, das heißt
- aus der am Disparitätseingang 26 bzw. 36 eingehenden Disparitätsinformation D_in = 0 wird die am Disparitätsausgang 28 bzw. 38 ausgehende Disparitätsinformation D_out = 1 oder
- aus der am Disparitätseingang 26 bzw. 36 eingehenden Disparitätsinformation D_in = 1 wird die am Disparitätsausgang 28 bzw. 38 ausgehende Disparitätsinformation D_out = 0.

Damit ist bestimmt, welche Disparität das folgende oder nächste unbalancierte Ausgangssymbol aufweisen soll, wobei die Disparitätsinformation
- als im Falle eines DC-balanciert ausgegebenen Symbols unveränderte Disparitätsinformation (D_out = D_in) und
- als im Falle eines nicht DC-balanciert ausgegebenen Symbols invertierte Disparitätsinformation (D_in = 0 --> D_out = 1 oder D_in = 1 --> D_out = 0) durch jeden der fünf 5b/6b-Kodierblöcke 20 und durch den 2b/2b-Kodierblock 30 und von dort wieder weiter zum ersten (, in Fig. 1 obersten) der fünf 5b/6b-Kodierblöcke 20 weitergereicht wird.

Hat also ein unbalanciertes Ausgangssymbol negative Disparität, also zwei Nullen mehr als Einsen, das heißt
- vier Nullen und zwei Einsen im Falle des 5b/6b-Kodierblocks 20 bzw.
- zwei Nullen und keine Eins im Falle des 2b/2b-Kodierblocks 30, so wird die vom vorherigen Ausgangssymbol kommende Disparitätsinformation invertiert an den nächsten Kodierblock 20 bzw. 30 weitergeleitet, der abhängig davon, ob sein Ausgangssymbol unbalanciert oder balanciert ist, den Zustand der Disparitätsinformation wiederum invertiert oder unverändert belässt; insbesondere wird das folgende unbalancierte Ausgangssymbol mit positiver Disparität erzeugt.

Hat hingegen ein unbalanciertes Ausgangssymbol positive Disparität, also zwei Einsen mehr als Nullen, das heißt
- zwei Nullen und vier Einsen im Falle des 5b/6b-Kodierblocks 20 bzw.
- keine Null und zwei Einsen im Falle des 2b/2b-Kodierblocks 30,
   so wird die vom vorherigen Ausgangssymbol kommende Disparitätsinformation invertiert an den nächsten Kodierblock 20 bzw. 30 weitergeleitet, der abhängig davon, ob sein Ausgangssymbol unbalanciert oder balanciert ist, den Zustand der Disparitätsinformation wiederum invertiert oder unverändert belässt; insbesondere wird das folgende unbalancierte Ausgangssymbol mit negativer Disparität erzeugt.

Hat schließlich ein Ausgangssymbol neutrale Disparität, das heißt ist das Ausgangssymbol DC-balanciert, so wird die vom vorherigen Ausgangssymbol kommende Disparitätsinformation unverändert an den nächsten Kodierblock 20 bzw. 30 weitergeleitet, der abhängig davon, ob sein Ausgangssymbol balanciert oder unbalanciert ist, den Zustand der Disparitätsinformation wiederum unverändert belässt oder invertiert.

Die Wahl, ob in den exemplarischen Kodiertabellen gemäß Fig. 2 und gemäß Fig. 3A, Fig. 3B im Falle eines unbalancierten Ausgangsworts das Primary-Ausgangswort oder das Alternate-Ausgangswort ausgegeben wird, wird durch den Zustand der eingehenden Disparitätsinformation D_in dergestalt bestimmt, dass diejenige Disparität der zur Wahl stehenden Ausgangssymbole oder Ausgangswörter ausgegeben wird, die invers zur Disparität des vorhergehenden unbalancierten Ausgangssymbols oder Ausgangsworts ist.

Mit dieser Vorgehensweise wird sichergestellt, dass sich über ausreichend viele Ausgangssymbole Gleichspannungsfreiheit einstellt.

Hierbei kann zwischen zwei unbalancierten Ausgangssymbolen eine beliebige Anzahl von balancierten Ausgangssymbolen liegen, so zum Beispiel kein, ein, mehrere oder viele balancierte Ausgangssymbole zwischen zwei unbalancierten Ausgangssymbolen.

Der Aufbau und die Funktion des Dekodierers 60 sind im Wesentlichen spiegelbildlich zu vorstehend beschriebenem/r Aufbau und Funktion des Kodierers 10:
Mittels des Dekodierers 60 ist die Dekodierung des vom Kodierer 10 zur Verfügung gestellten DC-balancierten Datenstroms in einen 27 Bit breiten fehlerfreien Datenstrom realisierbar.

Nachdem der vom Kodierer 10 kommende, mittels des Multiplexers 40 serialisierte Datenstrom zunächst mittels eines dem Dekodierer 60 vorgeschalteten 1-zu-32-Demultiplexers 50 (sogenannter Demux) wieder in eine Breite von 32 Bit deserialisiert wird, kann für die Dekodierung jeder der fünf 6b/5b-Dekodierblöcke 70 durch seinen Dateneingang 72 sechs Bit breite digitale Signale aufnehmen und in ein fünf Bit breites digitales Wort wandeln, das durch den jeweiligen Datenausgang 74 ausgegeben werden (in Fig. 1 sind die Bezugszeichen 72, 74 anhand des mittleren der fünf 6b/5b-Dekodierblöcke 70 veranschaulicht, gelten aber für alle fünf 6b/5b-Dekodierblöcke 70 in gleicher Weise).

Des Weiteren weist jeder der fünf 6b/5b-Dekodierblöcke 70 einen Disparitätseingang 76 für die eingehende Disparitätsinformation D_in und einen Disparitätsausgang 78 für die ausgehende Disparitätsinformation D_out auf, denn es wird neben den Daten auch die Disparität verarbeitet (in Fig. 1 sind die Bezugszeichen 76, 78 anhand des mittleren der fünf 6b/5b-Dekodierblöcke 70 veranschaulicht, gelten aber für alle fünf 6b/5b-Dekodierblöcke 70 in gleicher Weise).

Parallel zu den fünf 6b/5b-Dekodierblöcken 70 ist ein 2b/2b-Dekodierblock 80 geschaltet, der ebenfalls einen Dateneingang 82 und einen Datenausgang 84 aufweist. Des Weiteren weist der 2b/2b-Dekodierblock 80 einen Disparitätseingang 86 für die eingehende Disparitätsinformation D_in und einen Disparitätsausgang 88 für die ausgehende Disparitätsinformation D_out auf, denn es wird neben den Daten auch die Disparität verarbeitet.

Für die (in der rechten Hälfte der Fig. 1 dargestellte) Dekodierseite sollen hinsichtlich des Weiterreichens der Disparitätsinformation, sei es
- in Form von Belassen bei einem balancierten Symbol oder balancierten Wort oder
- in Form von Invertieren bei einem unbalancierten Symbol oder unbalancierten Wort,
vollumfänglich die vorstehenden Erläuterungen zur (in der linken Hälfte der Fig. 1 dargestellten) Kodierseite.

### Bezugszeichenliste

- 100: Schaltungsanordnung
- 10: Kodierer
- 20: 5b/6b-Kodierblock des Kodierers 10
- 22: Dateneingang des 5b/6b-Kodierblocks 20
- 24: Datenausgang des 5b/6b-Kodierblocks 20
- 26: Disparitätseingang des 5b/6b-Kodierblocks 20
- 28: Disparitätsausgang des 5b/6b-Kodierblocks 20
- 30: 2b/2b-Kodierblock des Kodierers 10
- 32: Dateneingang des 2b/2b-Kodierblocks 30
- 34: Datenausgang des 2b/2b-Kodierblocks 30
- 36: Disparitätseingang des 2b/2b-Kodierblocks 30
- 38: Disparitätsausgang des 2b/2b-Kodierblocks 30
- 40: Multiplexer, insbesondere 32-zu-1-Multiplexer
- 50: Demultiplexer, insbesondere 1-zu-32-Demultiplexer
- 60: Dekodierer
- 70: 6b/5b-Dekodierblock des Dekodierers 60
- 72: Dateneingang des 6b/5b-Dekodierblocks 70
- 74: Datenausgang des 6b/5b-Dekodierblocks 70
- 76: Disparitätseingang des 6b/5b-Dekodierblocks 70
- 78: Disparitätsausgang des 6b/5b-Dekodierblocks 70
- 80: 2b/2b-Dekodierblock des Dekodierers 60
- 82: Dateneingang des 2b/2b-Dekodierblocks 80
- 84: Datenausgang des 2b/2b-Dekodierblocks 80
- 86: Disparitätseingang des 2b/2b-Dekodierblocks 80
- 88: Disparitätsausgang des 2b/2b-Dekodierblocks 80
- D_in: eingehende Disparitätsinformation
- D_out: ausgehende Disparitätsinformation

## Patentansprüche

1. Schaltungsanordnung (100) zum Kodieren und/oder Dekodieren eines Datenstroms unter Verwendung einer 27 Bit/32 Bit-Kodierung/-Dekodierung, **gekennzeichnet**
- **durch** mindestens einen Kodierer (10)
-- mit fünf parallel zueinander angeordneten, jeweils mindestens einen Dateneingang (22) und mindestens einen Datenausgang (24) aufweisenden 5b/6b-Kodierblöcken (20), die jeweils mindestens einen Disparitätseingang (26) für mindestens eine eingehende Disparitätsinformation (D_in) und mindestens einen Disparitätsausgang (28) für die ausgehende Disparitätsinformation (D_out) aufweisen, und
-- mit einem parallel zu den 5b/6b-Kodierblöcken (20) angeordneten, mindestens einen Dateneingang (32) und mindestens einen Datenausgang (34) aufweisenden 2b/2b-Kodierblock (30), der mindestens einen Disparitätseingang (36) für die eingehende Disparitätsinformation (D_in) und mindestens einen Disparitätsausgang (38) für die ausgehende Disparitätsinformation (D_out) aufweist,
wobei die Disparitätsinformation (D_in) bei Passieren eines jeden der 5b/6b-Kodierblöcke (20) sowie bei Passieren des 2b/2b-Kodierblocks (30) in Abhängigkeit von der D[irect]C[urrent]-Balancierung des vom jeweiligen 5b/6b-Kodierblock (20) sowie vom 2b/2b-Kodierblock (30) ausgehenden Datensignals unverändert bleibt (D_out = D_in) oder invertiert wird (D_in = 0 --> D_out = 1 oder D_in = 1 --> D_out = 0), so dass die Disparitätsinformation unverändert oder invertiert an den jeweils nächsten Kodierblock (20 bzw. 30) weitergegeben wird, und/oder
- **durch** mindestens einen Dekodierer (60)
-- mit fünf parallel zueinander angeordneten, jeweils mindestens einen Dateneingang (72) und mindestens einen Datenausgang (74) aufweisenden 6b/5b-Dekodierblöcken (70), die jeweils mindestens einen Disparitätseingang (76) für mindestens eine eingehende Disparitätsinformation (D_in) und mindestens einen Disparitätsausgang (78) für die ausgehende Disparitätsinformation (D_out) aufweisen, und
-- mit einem parallel zu den 6b/5b-Dekodierblöcken (70) angeordneten, mindestens einen Dateneingang (82) und mindestens einen Datenausgang (84) aufweisenden 2b/2b-Dekodierblock (80), der mindestens einen Disparitätseingang (86) für die eingehende Disparitätsinformation (D_in) und mindestens einen Disparitätsausgang (88) für die ausgehende Disparitätsinformation (D_out) aufweist,
wobei die Disparitätsinformation (D_in) bei Passieren eines jeden der 6b/5b-Dekodierblöcke (70) sowie bei Passieren des 2b/2b-Dekodierblocks (80) in Abhängigkeit von der D[irect]C[urrent]-Balancierung des im jeweiligen 6b/5b-Dekodierblock (70) sowie im 2b/2b-Dekodierblock (80) eingehenden Datensignals unverändert bleibt (D_out = D_in) oder invertiert wird (D_in = 0 --> D_out = 1 oder D_in = 1 --> D_out = 0), so dass die Disparitätsinformation unverändert oder invertiert an den jeweils nächsten Dekodierblock (70 bzw. 80) weitergegeben wird.

2. Schaltungsanordnung gemäß Anspruch 1, **dadurch gekennzeichnet, dass** von vier möglichen Eingangssignalen (00, 01, 10, 11) für den Dateneingang (32 bzw. 82) des 2b/2b-Kodierblocks (30) bzw. des 2b/2b-Dekodierblocks (80) unter Nutzung der Disparitätsinformation (D_in, D_out) drei Eingangssignale, insbesondere als DC-balanciertes Signal, einsetzbar sind.

3. Schaltungsanordnung gemäß Anspruch 2, **dadurch gekennzeichnet, dass** der Dateneingang (32 bzw. 82) des 2b/2b-Kodierblocks (30) bzw. des 2b/2b-Dekodierblocks (80)
- mit mindestens einem D[ata]E[nable]-Signal und
- mit mindestens einem H[orizontal]S[ynchronisation]-Signal beaufschlagbar ist.

4. Schaltungsanordnung gemäß mindestens einem der Ansprüche 1 bis 3, **dadurch gekennzeichnet,**
- **dass** dem Kodierer (10) mindestens ein Multiplexer (40), insbesondere mindestens ein 32-zu-1-Multiplexer, nachgeschaltet ist, mittels dessen der vom Kodierer (10) ausgegebene Datenstrom serialisierbar ist, und
- **dass** dem Dekodierer (60) mindestens ein Demultiplexer (50), insbesondere mindestens ein 1-zu-32-Demultiplexer, vorgeschaltet ist, mittels dessen der vom Multiplexer (40) ausgegebene serielle Datenstrom deserialisierbar ist.

5. Verfahren zum Kodieren und/oder Dekodieren eines Datenstroms unter Verwendung einer 27 Bit/32 Bit-Kodierung/-Dekodierung, **gekennzeichnet**
- **durch** das Kodieren mittels fünf parallel zueinander angeordneter, jeweils mindestens einen Dateneingang (22) und mindestens einen Datenausgang (24) aufweisender 5b/6b-Kodierblöcken (20) und mittels eines parallel zu den 5b/6b-Kodierblöcken (20) angeordneten, mindestens einen Dateneingang (32) und mindestens einen Datenausgang (34) aufweisenden 2b/2b-Kodierblocks (30), wobei eine Disparitätsinformation (D_in) bei Passieren eines jeden der 5b/6b-Kodierblöcke (20) sowie bei Passieren des 2b/2b-Kodierblocks (30) in Abhängigkeit von der D[irect]C[urrent]-Balancierung des vom jeweiligen 5b/6b-Kodierblock (20) sowie vom 2b/2b-Kodierblock (30) ausgehenden Datensignals unverändert bleibt (D_out = D_in) oder invertiert wird (D_in = 0 --> D_out = 1 oder D_in = 1 --> D_out = 0), so dass die Disparitätsinformation unverändert oder invertiert an den jeweils nächsten Kodierblock (20 bzw. 30) weitergegeben wird, und/oder
- **durch** das Dekodieren mittels fünf parallel zueinander angeordneter, jeweils mindestens einen Dateneingang (72) und mindestens einen Datenausgang (74) aufweisender 6b/5b-Dekodierblöcken (70) und mittels eines parallel zu den 6b/5b-Dekodierblöcken (70) angeordneten, mindestens einen Dateneingang (82) und mindestens einen Datenausgang (84) aufweisenden 2b/2b-Dekodierblocks (80), wobei eine Disparitätsinformation (D_in) bei Passieren eines jeden der 6b/5b-Dekodierblöcke (70) sowie bei Passieren des 2b/2b-Dekodierblocks (80) in Abhängigkeit von der D[irect]C[urrent]-Balancierung des im jeweiligen 6b/5b-Dekodierblock (70) sowie im 2b/2b-Dekodierblock (80) eingehenden Datensignals unverändert bleibt (D_out = D_in) oder invertiert wird (D_in = 0 --> D_out = 1 oder D_in = 1 --> D_out = 0), so dass die Disparitätsinformation unverändert oder invertiert an den jeweils nächsten Dekodierblock (70 bzw. 80) weitergegeben wird.

6. Verfahren gemäß Anspruch 5, **dadurch gekennzeichnet, dass** von vier möglichen Eingangssignalen (00, 01, 10, 11) für den Dateneingang (32 bzw. 82) des 2b/2b-Kodierblocks (30) bzw. des 2b/2b-Dekodierblocks (80) unter Nutzung der Disparitätsinformation (D_in, D_out) drei Eingangssignale, insbesondere als DC-balanciertes Signal, eingesetzt werden.

7. Verfahren gemäß Anspruch 6, **dadurch gekennzeichnet, dass** der Dateneingang (32 bzw. 82) des 2b/2b-Kodierblocks (30) bzw. des 2b/2b-Dekodierblocks (80)
- mit mindestens einem D[ata]E[nable]-Signal und
- mit mindestens einem H[orizontal]S[ynchronisation]-Signal beaufschlagt wird.

8. Verfahren gemäß mindestens einem der Ansprüche 5 bis 7, **dadurch gekennzeichnet,**
- **dass** der vom Kodierer (10) ausgegebene Datenstrom mittels mindestens eines dem Kodierer (10) nachgeschalteten Multiplexers (40), insbesondere mittels mindestens eines 32-zu-1-Multiplexers, serialisiert wird und
- **dass** der vom Multiplexer (40) ausgegebene serielle Datenstrom mittels mindestens eines dem Dekodierer (60) vorgeschalteten Demultiplexers (50), insbesondere mittels mindestens eines 1-zu-32-Demultiplexers, deserialisiert wird.

9. Verwendung mindestens einer Schaltungsanordnung (100) gemäß mindestens einem der Ansprüche 1 bis 4 und/oder eines Verfahrens gemäß mindestens einem der Ansprüche 5 bis 8 zur serialisierten optischen und/oder elektrischen Signalübertragung zwischen mindestens einer bis zu 24 Bit breiten digitalen R[ot]G[rün]B[lau]-Datenquelle, insbesondere mindestens einer, zum Beispiel hochauflösenden und/oder zum Beispiel als Bildquelle fungierenden, Kamera oder mindestens einem Applikationsprozessor, und mindestens einer bis zu 24 Bit breiten digitalen R[ot]G[rün]B[lau]-Datensenke, insbesondere mindestens einem Applikationsprozessor oder mindestens einem, zum Beispiel hochauflösenden und/oder zum Beispiel als Bildsenke fungierenden, Display oder Monitor.

## Claims

1. A circuit arrangement (100) provided for coding and/or decoding of a data stream using 27 Bit/32 Bit coding/decoding,
**characterized**
- **by** at least one coder (10)
-- with five 5b/6b coder blocks (20) arranged in parallel to each other and each comprising at least one data input (22), at least one data output (24), at least one disparity input (26) for at least one incoming disparity information (D_in) and at least one disparity output (28) for the outgoing disparity information (D_out), and
-- with a 2b/2b coder block (30) arranged in parallel to the 5b/6b coder blocks (20) and comprising at least one data input (32), at least one data output (34), at least one disparity input (36) for the incoming disparity information (D_in) and at least one disparity output (38) for the outgoing disparity information (D_out),
wherein the disparity information (D_in), when passing each of the 5b/6b coder blocks (20) and when passing the 2b/2b coder block (30), remains unchanged (D_out = D_in) or is inverted (D_in = 0 --> D_out = 1 or D_in = 1 --> D_out = 0) depending on the D[irect]C[urrent] balancing of the data signal going out from the respective 5b/6b coder block (20) and from the 2b/2b coder block (30) such that the disparity information is forwarded to the respectively next coder block (20 or 30) in unchanged form or in inverted form, and/or
- by at least one decoder (60)
-- with five 6b/5b decoder blocks (70) arranged in parallel to each other and each comprising at least one data input (72), at least one data output (74), at least one disparity input (76) for at least one incoming disparity information (D_in) and at least one disparity output (78) for the outgoing disparity information (D_out), and
-- with a 2b/2b decoder block (80) arranged in parallel to the 6b/5b decoder blocks (70) and comprising at least one data input (82), at least one data output (84), at least one disparity input (86) for the incoming disparity information (D_in) and at least one disparity output (88) for the outgoing disparity information (D_out),
wherein the disparity information (D_in), when passing each of the 6b/5b decoder blocks (70) and when passing the 2b/2b decoder block (80), remains unchanged (D_out = D_in) or is inverted (D_in = 0 --> D_out = 1 or D_in = 1 --> D_out = 0) depending on the D[irect]C[urrent] balancing of the data signal arriving in the respective 6b/5b decoder block (70) and in the 2b/2b decoder block (80) such that the disparity information is forwarded to the respectively next decoder block (70 or 80) in unchanged form or in inverted form.

2. The circuit arrangement according to claim 1, **characterized in that** of four possible input signals (00, 01, 10, 11), three input signals are usable, in particular as a DC balanced signal, for the data input (32 or 82) of the 2b/2b coder block (30) or of the 2b/2b decoder block (80) utilizing the disparity information (D_in, D_out).

3. The circuit arrangement according to claim 2, **characterized in that** the data input (32 or 82) of the 2b/2b coder block (30) or of the 2b/2b decoder block (80) is providable
- with at least one D[ata]E[nable] signal and
- with at least one H[orizontal]S[ynchronization] signal.

4. The circuit arrangement according to at least one of claims 1 to 3, **characterized in**
- **that** at least one multiplexer (40), in particular at least one 32-to-1 multiplexer, is arranged downstream of the coder (10) and that the data stream outputted by the coder (10) can be serialized by means of said multiplexer (40), and
- **that** at least one demultiplexer (50), in particular at least one 1-to-32 demultiplexer, is arranged upstream of the decoder (60) and that the serial data stream outputted by the multiplexer (40) can be deserialized by means of said demultiplexer (50).

5. A method for coding and/or decoding a data stream using 27 Bit/32 Bit coding/decoding, **characterized**
- **by** coding using five 5b/6b coder blocks (20) arranged in parallel to each other and each comprising at least one data input (22) as well as at least one data output (24), and using a 2b/2b coder block (30) arranged in parallel to the 5b/6b coder blocks (20) and comprising at least one data input (32) as well as at least one data output (34), wherein a disparity information (D_in), when passing each of the 5b/6b coder blocks (20) and when passing the 2b/2b coder block (30), remains unchanged (D_out = D_in) or is inverted (D_in = 0 --> D_out = 1 or D_in = 1 --> D_out = 0) depending on the D[irect]C[urrent] balancing of the data signal going out from the respective 5b/6b coder block (20) and from the 2b/2b coder block (30) such that the disparity information is forwarded to the respectively next coder block (20 or 30) in unchanged form or in inverted form, and/or
- by decoding using five 6b/5b decoder blocks (70) arranged in parallel to each other and each comprising at least one data input (72) as well as at least one data output (74), and using a 2b/2b decoder block (80) arranged in parallel to the 6b/5b decoder blocks (70) and comprising at least one data input (82) as well as at least one data output (84), wherein the disparity information (D_in), when passing each of the 6b/5b decoder blocks (70) and when passing the 2b/2b decoder block (80), remains unchanged (D_out = D_in) or is inverted (D_in = 0 --> D_out = 1 or D_in = 1 --> D_out = 0) depending on the D[irect]C[urrent] balancing of the data signal arriving in the respective 6b/5b decoder block (70) and in the 2b/2b decoder block (80) such that the disparity information is forwarded to the respectively next decoder block (70 or 80) in unchanged form or in inverted form.

6. The method according to claim 5, **characterized in that** of four possible input signals (00, 01, 10, 11), three input signals are used, in particular as a DC balanced signal, for the data input (32 or 82) of the 2b/2b coder block (30) or of the 2b/2b decoder block (80) utilizing the disparity information (D_in, D_out).

7. The method according to claim 6, **characterized in that** the data input (32 or 82) of the 2b/2b coder block (30) or of the 2b/2b decoder block (80) is provided
- with at least one D[ata]E[nable] signal and
- with at least one H[orizontal]S[ynchronization] signal.

8. The method according to at least one of claims 5 to 7, **characterized in**
- **that** the data stream outputted by the coder (10) is serialized by means of at least one multiplexer (40), in particular by means of at least one 32-to-1 multiplexer, arranged downstream of the coder (10), and
- **that** the serial data stream outputted by the multiplexer (40) is deserialized by means of at least one demultiplexer (50), in particular by means of at least one 1-to-32 demultiplexer, arranged upstream of the decoder (60).

9. Use of at least one circuit arrangement (100) according to at least one of claims 1 to 4 and/or a method according to at least one of claims 5 to 8 for the serialized optical and/or electrical signal transmission between at least one up to 24 bit wide digital R[ed]G[reen]B[lue] data source, in particular at least one camera, for example having a high resolution and/or for example acting as an image source, or at least one application processor, and at least one up to 24 bit wide digital R[ed]G[reen]B[lue] data sink, in particular at least one application processor or at least one display or monitor, for example having a high resolution and/or for example acting as an image sink.

## Revendications

1. Ensemble circuit (100) pour le codage et/ou décodage d'un flux de données en utilisant un codage/décodage 27 bits/32 bits,
**caractérisé**
- **par** au moins un codeur (10)
-- avec cinq blocs de codage 5b/6b (20) disposés parallèlement les uns aux autres, comportant respectivement au moins une entrée de données (22) et au moins une sortie de données (24), qui comportent respectivement au moins une entrée de disparité (26) pour au moins une information de disparité (D_in) entrante et au moins une sortie de disparité (28) pour l'information de disparité (D_out) sortante, et
-- avec un bloc de codage 2b/2b (30) disposé parallèlement aux blocs de codage 5b/6b (20), comportant respectivement au moins une entrée de données (32) et au moins une sortie de données (34), qui comporte au moins une entrée de disparité (36) pour l'information de disparité (D_in) entrante et au moins une sortie de disparité (38) pour l'information de disparité (D_out) sortante,
l'information de disparité (D_in) restant inchangée (D_out = D_in) ou étant inversée (D_in = 0 --> D_out = 1 ou D_in = 1 --> D_out = 0) lors du passage par un des blocs de codage 5b/6b (20) ainsi que lors du passage par le bloc de codage 2b/2b (30) en fonction de l'équilibrage en C[ourant]C[ontinu] du signal de données sortant du bloc de codage 5b/6b (20) respectif ainsi que du bloc de codage 2b/2b (30), de sorte que l'information de disparité est transmise inchangée ou inversée au bloc de codage respectif suivant (20 ou 30), et/ou
- par au moins un décodeur (60)
-- avec cinq blocs de décodage 6b/5b (70) disposés parallèlement les uns aux autres, comportant respectivement au moins une entrée de données (72) et au moins une sortie de données (74), qui comportent respectivement au moins une entrée de disparité (76) pour au moins une information de disparité (D_in) entrante et au moins une sortie de disparité (78) pour l'information de disparité (D_out) sortante, et
-- avec un bloc de décodage 2b/2b (80) disposé parallèlement aux blocs de décodage 6b/5b (70), comportant au moins une entrée de données (82) et au moins une sortie de données (84), qui comporte au moins une entrée de disparité (86) pour l'information de disparité (D_in) entrante et au moins une sortie de disparité (88) pour l'information de disparité (D_out) sortante,
l'information de disparité (D_in) restant inchangée (D_out = D_in) ou est inversée (D_in = 0 --> D_out = 1 ou D_in = 1 --> D_out = 0) lors du passage par un des blocs de décodage 6b/5b (70) ainsi que lors du passage par le bloc de décodage 2b/2b (80) en fonction de l'équilibrage en C[ourant]C[ontinu] du signal de données entrant dans le bloc de décodage 6b/5b (70) respectif ainsi que dans le bloc de décodage 2b/2b (80), de sorte que l'information de disparité est transmise inchangée ou inversée au bloc de décodage respectif suivant (70 ou 80).

2. Ensemble circuit selon la revendication 1, **caractérisé en ce que** sur les quatre signaux d'entrée possibles (00, 01, 10, 11) pour l'entrée de données (32 ou 82) du bloc de codage 2b/2b (30) ou du bloc de décodage 2b/2b (80) en utilisant l'information de disparité (D_in, D_out), trois signaux d'entrée peuvent être utilisés, notamment en tant que signal équilibré en CC.

3. Ensemble circuit selon la revendication 2, **caractérisé en ce que** l'on peut appliquer à l'entrée de données (32 ou 82) du bloc de codage 2b/2b (30) ou du bloc de décodage 2b/2b (80)
- au moins un signal D[onnées]V[alidées], et
- au moins un signal S[ynchronisation]H[orizontale].

4. Ensemble circuit selon au moins une quelconque des la revendications 1 à 3, **caractérisé en ce**
- **qu'**au moins un multiplexeur (40), notamment au moins un multiplexeur 32-à-1, est monté en aval du codeur (10), au moyen duquel le flux de données émis par le codeur (10) peut être sérialisé, et
- **qu'**au moins un démultiplexeur (50), notamment au moins un démultiplexeur 1-à-32, est monté en amont du décodeur (60), au moyen duquel le flux de données sériel émis par le multiplexeur (40) peut être désérialisé.

5. Procédé de codage et/ou de décodage d'un flux de données en utilisant un codage/décodage 27 bits/32 bits,
**caractérisé**
- **par** le codage au moyen de cinq blocs de codage 5b/6b (20) disposés parallèlement les uns aux autres, comportant respectivement au moins une entrée de données (22) et au moins une sortie de données (24) et au moyen d'un bloc de codage 2b/2b (30) disposé parallèlement aux blocs de codage 5b/6b (20), comportant au moins une entrée de données (32) et au moins une sortie de données (34), une information de disparité (D_in) restant inchangée (D_out = D_in) ou est inversée (D_in = 0 --> D_out = 1 ou D_in = 1 --> D_out = 0) lors du passage par un des blocs de codage 5b/6b (20) ainsi que lors du passage par le bloc de codage 2b/2b (30) en fonction de l'équilibrage en C[ourant]C[ontinu] du signal de données sortant du bloc de codage 5b/6b (20) respectif ainsi que du bloc de codage 2b/2b (30), de sorte que l'information de disparité est transmise inchangée ou inversée au bloc de codage respectif suivant (20 ou 30), et/ou
- par le décodage au moyen de cinq blocs de décodage 6b/5b (70) disposés parallèlement les uns aux autres, comportant respectivement au moins une entrée de données (72) et au moins une sortie de données (74) et au moyen d'un bloc de décodage 2b/2b (80) disposé parallèlement aux blocs de décodage 6b/5b (70), comportant au moins une entrée de données (82) et au moins une sortie de données (84), une information de disparité (D_in) restant inchangée (D_out = D_in) ou est inversée (D_in = 0 --> D_out = 1 ou D_in = 1 --> D_out = 0) lors du passage par un des blocs de décodage 6b/5b (70) ainsi que lors du passage par le bloc de décodage 2b/2b (80) en fonction de l'équilibrage en C[ourant]C[ontinu] du signal de données entrant dans le bloc de décodage 6b/5b (70) respectif ainsi que dans le bloc de décodage 2b/2b (80), de sorte que l'information de disparité est transmise inchangée ou inversée au bloc de décodage respectif suivant (70 ou 80).

6. Procédé selon la revendication 5, **caractérisé en ce que** sur les quatre signaux d'entrée possibles (00, 01, 10, 11) pour l'entrée de données (32 ou 82) du bloc de codage 2b/2b (30) ou du bloc de décodage 2b/2b (80) en utilisant l'information de disparité (D_in, D_out), trois signaux d'entrée peuvent être utilisés, notamment en tant que signal équilibré en CC.

7. Procédé selon la revendication 6, **caractérisé en ce qu'**on applique à l'entrée de données (32 ou 82) du bloc de codage 2b/2b (30) ou du bloc de décodage 2b/2b (80)
- au moins un signal D[onnées]V[alidées], et
- au moins un signal S[ynchronisation]H[orizontale].

8. Procédé selon l'une quelconque des revendications 5 à 7, **caractérisé en ce**
- **que** le flux de données émis par le codeur (10) est sérialisé au moyen d'au moins un multiplexeur (40) monté en aval du codeur (10), notamment au moyen d'au moins un multiplexeur 32-à-1, et
- **que** le flux de données sériel émis par le multiplexeur (40) est désérialisé au moyen d'au moins un démultiplexeur (50) monté en amont du décodeur (60), notamment au moyen d'au moins un démultiplexeur 1-à-32.

9. Utilisation d'au moins un ensemble circuit (100) selon au moins l'une quelconque des revendications 1 à 4 et/ou d'un procédé selon au moins l'une quelconque des revendications 5 à 8 pour la transmission optique et/ou électrique sérialisée de signaux entre au moins une source de données R[ouge]V[erte]B[leue] numérique d'une plage allant jusqu'à 24 bits, notamment au moins une caméra par exemple à haute définition et/ou par exemple fonctionnant comme source d'images, ou au moins un processeur d'application et au moins un collecteur de données R[ouge]V[ert]B[leu] numérique d'une plage allant jusqu'à 24 bits, notamment au moins un processeur d'application ou au moins un affichage ou écran par exemple à haute définition et/ou par exemple fonctionnant comme collecteur d'images.
